(19)

Europäisches
Patentamt
European
Patent Office
Office européen
des brevets

(11) **EP 2 595 193 A1**

(12) **EUROPEAN PATENT APPLICATION**

(43) Date of publication:
**22.05.2013 Bulletin 2013/21**

(51) Int Cl.:
**H01L 29/15** *(2006.01)*        **H01L 31/0352** *(2006.01)*

(21) Application number: **11189350.9**

(22) Date of filing: **16.11.2011**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **Hitachi, Ltd.**
**Chiyoda-ku**
**Tokyo 100-8280 (JP)**

(72) Inventors:
- **Andreev, Aleksey**
  **Cambridge, Cambridgeshire CB3 0HE (GB)**
- **Williams, David**
  **Cambridge, Cambridgeshire CB3 0HE (GB)**

- **Tsuchiya, Ryuta**
  **Tokyo, 100-8280 (JP)**
- **Watanabe, Keiji**
  **Tokyo, 100-8280 (JP)**
- **Saito, Shinichi**
  **Tokyo, 100-8280 (JP)**

(74) Representative: **Piotrowicz, Pawel Jan Andrzej et al**
**Venner Shipley LLP**
**Byron House**
**Cambridge Business Park**
**Cowley Road**
**Cambridge CB4 0WZ (GB)**

(54) **Multiple quantum well structure**

(57)    A multiple quantum well structure (1) comprises a multiple layer structure comprising alternating well and barrier layers (3, 4) comprising first and second materials respectively stacked in a first direction (z). Each barrier layer has a plurality of holes (6) filled with a third material so to form a plurality of respective bridge regions (9) which connect adjacent well layers. The bridge regions have dimensions of no more than 50 nm in directions (x, y) perpendicular to the first direction.

Fig. 1

EP 2 595 193 A1

## Description

The present invention relates to a multiple quantum well structure and to a photovoltaic cell comprising a multiple quantum well structure.

Photovoltaic or "solar" cells are often used as power sources in portable devices, such as desktop calculators, and in remotely-located systems, such as satellites. However, photovoltaic cells are set to play an increasingly important role in energy generation and are expected to replace power sources which rely on fossil fuels in some applications.

In a typical photovoltaic cell, photons generate excess charge carriers in a region formed by a p-n junction formed in bulk silicon. More recent photovoltaic cells use amorphous or thin-film silicon or are formed using other semiconducting materials, such as cadmium selenide.

An overview of photovoltaic cells can be found in Chapter 14 of "Physics of Semiconductor Devices", S. M. Sze, (2nd Edition, Wiley, 1981) and Chapter 8 of "Modern Semiconductor Device Physics" by M. A Green, ed. S. M. Sze, (Wiley, 1998).

Although much effort is being directed to finding suitable materials with high conversion efficiency, silicon is still commonly used in photovoltaic cells and several different approaches have been investigated with a view to increasing the efficiency of silicon-based photovoltaic cells.

For example, Lockwood D. J.: "Band Gap of Nanometer Thick Si/SiO2 Quantum Wells: Theory versus Experiment", Article no. 70991F, Proceedings Of The Society Of Photo-Optical Instrumentation Engineers (SPIE) Volume 7099, 2008, pages F991-F991 describes using thin silicon layers and silicon/silicon dioxide superlattices.

Some approaches involve patterning a thin film of silicon on a generally large (>0.5 $\mu$m) scale with the aim of increasing the efficiency of light trapping:

For example, Brendel R.: "A novel process for ultrathin monocrystalline silicon solar cells on glass", 14th European Photovoltaic Solar Energy Conference, Barcelona, Spain 30 June-4 July 1997 describes growing a thin, textured layer of monocrystalline silicon substrate having a periodicity of 13 $\mu$m. Shir D. et al.: "Performance of Ultrathin Silicon Solar Microcells with Nanostructures of Relief Formed by Soft Imprint Lithography for Broad Band Absorption Enhancement", Nano Letters, volume 10, 2010, pages 3041 to 3046 describes ultrathin microcells that include nanoscale features of relief on their surfaces formed by soft imprint lithography having a periodicity of about 500 nm and a feature diameter of 370 nm. Yoon J. et al.: "Ultrathin silicon solar microcells for semitransparent, mechanically flexible and microconcentrator module designs", Nature Materials, volume 7, 2008, pages 907 to 915 describes microcells formed from silicon bars having dimensions of 1.5 mm, 50 $\mu$m and 15 $\mu$m. Ferry V. E.: "Light trapping in ultrathin plasmonic solar cells", Optics Express, volume 18, 2010, pages A237 to A245 describes nanopatterned cells having a thin amorphous Si:H layer having thickness of 160 nm, a pitch of 500 nm and a feature size of 250 nm.

It is also known to form quantum dots and quantum wells using silicon.

For example, Oda S.: "NeoSilicon materials and silicon nanodevices", Material Science and Engineering B, volume 101, 2003, pages 19 to 13 describes a material formed of nanocrystalline silicon quantum dots having a diameter of 8 nm covered by an oxide of 1.5 nm thickness.

A silicon/silicon oxide quantum wells can be to tune the absorption wavelength of light. However, a drawback is that the introduction of even very thin layers of silicon dioxide is that the effective mass of charge carriers perpendicular to the layers is very high, as described in Rosini M. et al.: "Monte Carlo simulation of electron transport in Si/SiO2 superlattices: Vertical transport enhanced by a parallel field", Physical Review B, volume 66, 200, page 155332. This results in a very low mobility perpendicular to the layers compared to the mobility of parallel to the layers. Rölver R. et al.: "Si/SiO2 multiple quantum wells for all silicon tandem cells: Conductivity and photocurrent measurements", Thin Solid Films, volume 516, 2008, pages 6763 to 6766 reports a difference of four orders of magnitude in conductivity between vertical and lateral directions.

Suggestions have been made for improving vertical transport. These approaches concentrate on reducing the size of barrier. For example, Jiang C-W et al.: "Silicon quantum dot superlattices: Modeling of energy bands, densities of states, and mobilities for silicon tandem solar cell applications", Journal of Applied Physics, volume 99, 2006, page 114902 for example, by substituting silicon dioxide by silicon nitride or silicon carbide. Malguth E. et al.: "Development of ultra-thin tunneling oxides and Si/SiO2 nanostructures for the application in silicon solar cells", Physica Status Solidi A, volume 208, 2011, page 612 to 615 describes using a silicon-rich oxide.

EP 1 505 698 A describes a laser diode comprising a GaN/AlGaN superlattice in which holes (having a size of nanometres to micrometres) are formed in both GaN well layers and AlGaN barrier layers to reduce the driving voltage of the laser diode by reducing the series resistance of the superlattice. The superlattice is formed by using uneven growth of GaN and AlGaN resulting in a single-crystal superlattice having a random arrangement of semiconductor regions.

The materials used in EP 1 505 698 are significantly different from silicon and silicon oxide. For example, the band offset between silicon and silicon oxide is at least an order of magnitude higher than that between GaN and AlGaN.

Thus, even small variations in the configuration of a thin silicon oxide barrier layer (such as its thickness) would be expected to significantly alter the barrier coefficient of the barrier and, thus, detrimentally affect device characteristics.

The present invention seeks to improve transport in a multiple quantum well structure while maintaining control over the properties of the quantum wells and without reducing absorption substantially.

According to a first aspect of the present invention there is provided a multiple quantum well structure comprising a multiple layer structure comprising alternating well and barrier layers comprising first and second materials respectively stacked in a first direction, wherein each barrier layer has a plurality of holes filled with a third material so to form a plurality of respective bridge regions through the layer which connect adjacent well layers, the bridge regions having dimensions of no more than 50 nm in directions perpendicular to the first direction.

The invention is based, at least in part, on the insight that, provided bridge regions are sufficiently small, they can be used to improve charge carrier transport through a multiple quantum well structure without substantially affecting absorption characteristics of the structure, even when materials such as silicon and silicon oxide (and other silicon-based dielectrics) are used.

The first material may be silicon and the second material may be a dielectric material. The dielectric material may comprise silicon and may comprise, for example, silicon oxide and/or silicon nitride. The first and second materials may be the same or may be different. The quantum well structure need not be single crystal, for example, the well layers may be monocrystalline or polycrystalline and/or the barrier layers may, for example, amorphous. Each well layer is preferably continuous, e.g. without holes.

The bridge regions may have dimensions of no more than 40 nm, 20 nm or 10 nm in the directions perpendicular to the first direction.

Each well layer may have a thickness of between 1 nm and 10 nm. Each well layer may have a thickness of at least 10 nm. Each barrier layer may each have a thickness of between 1 nm and 10 nm, for example, between 2 nm and 5 nm.

According to a second aspect of the present invention there is provided a photovoltaic cell comprising first and second contacts and a multiple quantum well structure disposed between said first and second contacts.

According to a third aspect of the present invention there is provided a method comprising connecting a load across one or more photovoltaic cells and arranging the photovoltaic cell such that, during daytime, the photovoltaic cell is exposed to sunlight.

According to a fourth aspect of the present invention there is provided method of fabricating a multiple quantum well structure, the method comprising providing alternating well and barrier layers comprising first and second materials respectively stacked in a first direction, wherein each barrier layer has a plurality of holes filled with a third material so to form a plurality of respective bridge regions through the layer which connect adjacent well layers, the bridge regions having dimensions of no more than 50 nm.

Certain embodiments of the present invention will now be described, by way of example, with reference to the accompanying drawings in which:

Figure 1 is schematic cross sectional view of a multiple quantum well structure comprising quantum well layers and barrier layers, and nanobridges in the barrier layers;
Figure 1a is a magnified perspective view of a portion of the multiple quantum well structure shown in Figure 1;
Figure 2 is a schematic diagram of a photovoltaic cell;
Figure 3a is a schematic diagram of the band structure a multiple quantum well structure without nanobridges;
Figure 3b is a schematic diagram of the band structure a multiple quantum well structure which includes nanobridges;
Figures 4a and 4b illustrate first and second systems respectively used to model energy levels and wave functions using a simple effective mass model;
Figures 5a and 5b are plots of ground level dependence on momentum for two different matrix sizes;
Figure 6 is a log plot illustrating width of energy levels for different energy level numbers for the two structures shown in Figures 4a and 4b;
Figure 7 is a linear plot illustrating width of energy levels for different energy level numbers for the two structures shown in Figure 4b;
Figures 8a to 8h show probability distribution of wavefunctions for the first, second, third, fourth, fifth, sixth, twenty-ninth and thirtieth energy levels; and
Figure 9 is a process flow diagram of a method of fabricating a multiple quantum well structure.

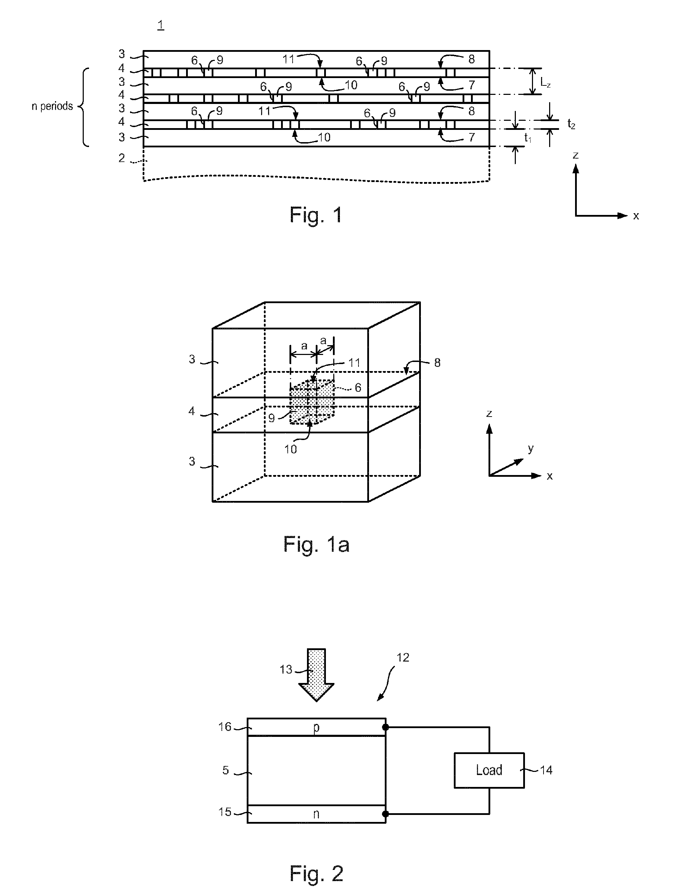

Referring to Figure 1, a multiple quantum well structure 1 in accordance with the present invention is shown.

The structure 1 includes an optional substrate 2 and alternating quantum well and barrier layers 3, 4 comprising first and second materials respectively which form a stack 5. The quantum well and barrier layers 3, 4 are stacked in a first direction (in Figure 1 shown to be along the z-axis). Each quantum well layer 3 has a first thickness, $t_1$, and each barrier layer 4 has a second thickness, $t_2$. The quantum well and barrier layers 3, 4 are repeated $n$ times, where n is an integer or half integer.

In this example, the quantum well layers 3 and the barrier layers 4 comprise silicon (Si) and silicon dioxide ($SiO_2$) respectively and have thicknesses in the range of about 1 nm to about 10 nm. The quantum well layer 3 can comprise other semiconductor materials, such as germanium (Ge) or tin (Sn), and the barrier layers 4 can comprise other dielectric materials, such as silicon nitride ($Si_xN_y$) or silicon oxynitride ($Si_xN_yO_z$), or semiconductor materials having a wider band gap than the band gap of the material used in the quantum well, such as silicon carbide (SiC). The value of $n$ may have a value of at least 10 or at least 20. The value of $n$ may have a value no more than 200, no more than 400 or no more than 1000. The value of $n$ is typically between about 10 and 200. Due to the arrangement and thicknesses of the layers 3, 4, the structure 1 may be colloquially referred to as a "superlattice" even though the structure 1 may not be single crystal.

Referring also to Figure 1a, each barrier layer 4 has a plurality of holes 6 between opposite surfaces 7, 8 of the layer 4.

The holes 6 are filled with a third material so to form a plurality of bridge regions 9 (herein also referred to as "nanobridges" or "inclusions") which connect adjacent well layers 4. The holes 6 and, thus, nanobridges 9 have dimensions of no more than 50 nm in second and third directions (x- and y- axes) perpendicular to the first direction. In this example, the holes 6 have first and second lateral dimensions, a. The nanobridges 9 have the same height (i.e. the same thickness) as a barrier layer 4.

The bridge regions 9 are preferably randomly positioned. The bridge regions 9 preferably occupy a total area of no more than 0.01 of the area of the barrier layer 4. The density of bridge regions 9 may be between $10^{11}$ cm$^{-2}$ and $10^{13}$ cm$^{-2}$. The density of bridge regions 9 typically may be about 2 to $5 \times 10^{12}$ cm$^{-2}$.

The bridge regions 9 also comprise silicon. However, the bridge regions 9 may comprise a material, such as silicon germanium ($Si_{1-x}Ge_x$), which is different from the material comprising the quantum well layer 3. Preferably, the bridge regions 9 comprise a material having the same band gap or a smaller band gap than the material comprising the quantum well layer.

Each nanobridge 9 is directly in contact with neighbouring quantum well layers 3. The nanobridge 9 and quantum well layers 3 form first and second interfaces 10, 11 having first and second areas $A_1$ and $A_2$ respectively. No tunnel barrier is placed between the nanobridge 9 and the quantum well layers 3. Thus, transport between the quantum well layers 3 through the nanobridge 9 is controlled by virtue of band offset alignment of the nanobridge and quantum well layer materials and the size of the nanobridge 9.

The bridge regions 9 operate in substantially a similar way to bridge regions described in EP 1 860 600 A and EP 2 187 445, which are incorporated herein by reference.

Referring also to Figure 2, a photovoltaic cell 12 is shown. The photovoltaic cell 12 is responsive to light 13 to drive a current through load 14 connected across the cell.

The stack 5 can serve as an active region which absorbs light 13 at a characteristic wavelength, $\lambda$, and in which electrons and holes can be separated. As shown in Figure 2, the stack 5 can be sandwiched between an n-type semiconductor region 15 and a p-type semiconductor region 16. In this example, the p-type semiconductor region 16 is disposed on a front face of the cell 12 and so is transparent.

The photovoltaic cell 12 can be more complex. For example, the photovoltaic cell 12 may be a multi-junction photovoltaic cell and the stack 5 may form one of the active regions. The photovoltaic cell 12 may include a light concentrator and/or other structures which increase device efficiency.

Furthermore, the photovoltaic cell 12 may include more than one stack 5, each stack formed of different materials and/or having different (sets of) well and barrier layer thicknesses, such that each stack is tuned to absorb light at a different characteristic wavelengths, $\lambda_1$, $\lambda_2$, $\lambda_3$, etc., where ($\lambda_1 \neq \lambda_2 \neq \lambda_3$).

Referring again to Figures 1 and 1a, the role of the nanobridges 9 is to enhance and control vertical transport (i.e. transport along the z-axis). The nanobridges 9 provide channels for transport. The lateral size of the nanobridges 9 determines the spectrum of carriers in the quantum well layers 3.

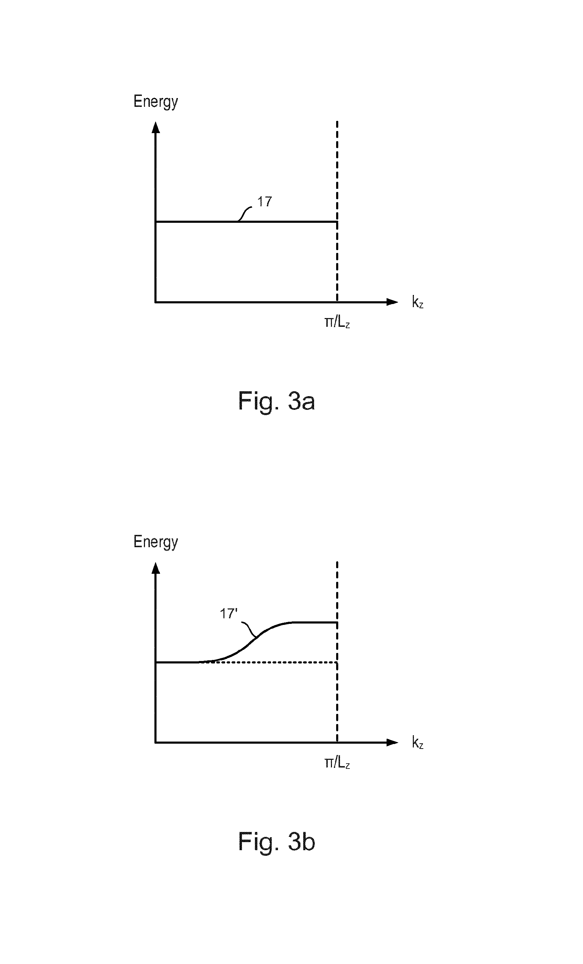

Figure 3a schematically illustrates the band structure of the multiple quantum well structure 1 without any nanobridges. $L_z$ is the period of the structure 1 along the z-axis. As shown in Figure 3a, the band edge 17 is constant for a vertical wavevector, $k_z$, between 0 and $\pi/L_z$.

Figure 3b schematically illustrates the band structure of the multiple quantum well structure 1 with nanobridges 9. As shown in Figure 3b, when nanobridges 9 are present, the energy of the band edge 17' increases

The presence of the nanobridges 9 allows charge carriers to have much higher mobility along the z-direction, i.e. perpendicular to the plane. The general expression for the energy levels in the superlattice with nanobridges 9 is:

$$E_n(k_\parallel, k_z) = \Delta_n(k_\parallel)(1 - \cos(\pi k / d)) \qquad (1)$$

where $E_n$ is the energy of the n-th sub-band of a quantum well, $k_\parallel$ and $k_z$ are lateral and vertical momentum components and $\Delta_n$ is the width of the band in $k_z$ direction.

As shown in Figure 3b, the width of each superlattice band increases for

$$k_\parallel \sim \pi / (size\ of\ the\ bridge) \qquad (2)$$

The effective mass for the n-th band in z-direction is proportional to the inverse band width $1/\Delta n(k_\parallel)$. Mobility is, in turn, proportional to the inverse effective mass (assuming a simple effective mass model).

Thus, mobility increases as averaged band width (averaged over lateral momentum and band number using corresponding functions as statistical weight), namely

$$\mu \sim < \Delta_n(k_\parallel) > \qquad (3)$$

By controlling the size of the nanobridges, vertical mobility of the charge carriers can be controlled.

The nanobridges 9 in the same layer and/or in different layers can be of different sizes. The composition(s) and size(s) of the nanobridges 9 can be adjusted to keep the same desired band gap and provide efficient carrier (electron and hole) transport. The composition and size of the nanobridges 9 can be determined by computer simulation and/or by experiment.

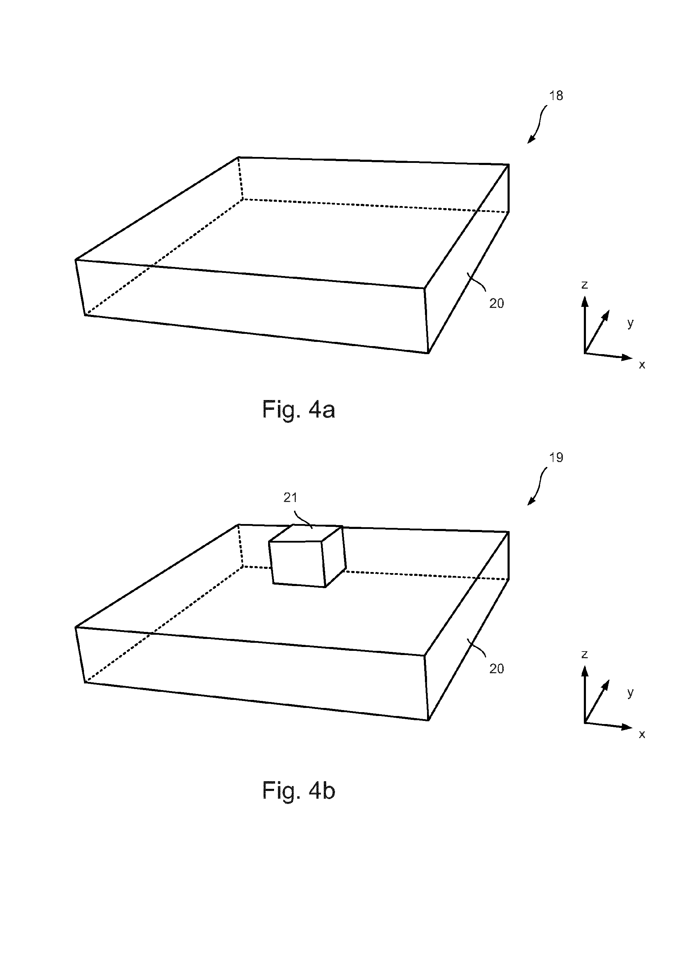

Referring to Figures 4a and 4b, the effect of the nanobridges 9 is modelled by comparing first and second structures 18, 19.

As shown in Figure 4a, the first structure 18 comprises a block 20 of silicon, which is square in plan view, having a thickness (in the z-direction) of 2.5 nm and lateral dimensions (in x- and y- directions) of $15 \times 15$ nm.

The second structure 19 is the same as the first structure 18 but includes a silicon nanobridge 21 having a thickness of 2 nm and lateral dimensions of $2.5\ nm \times 2.5$ nm. Thus, a material made based on such a structure would have a (vertical) period of 4.5 nm and a nanobridge density of about $4 \times 10^{12}\ cm^{-2}$.

A simple effective mass model is used to calculate the energy levels and wavefunctions for the first and second structures 18, 19 using an isotropic effective mass of 0.7 $m_0$.

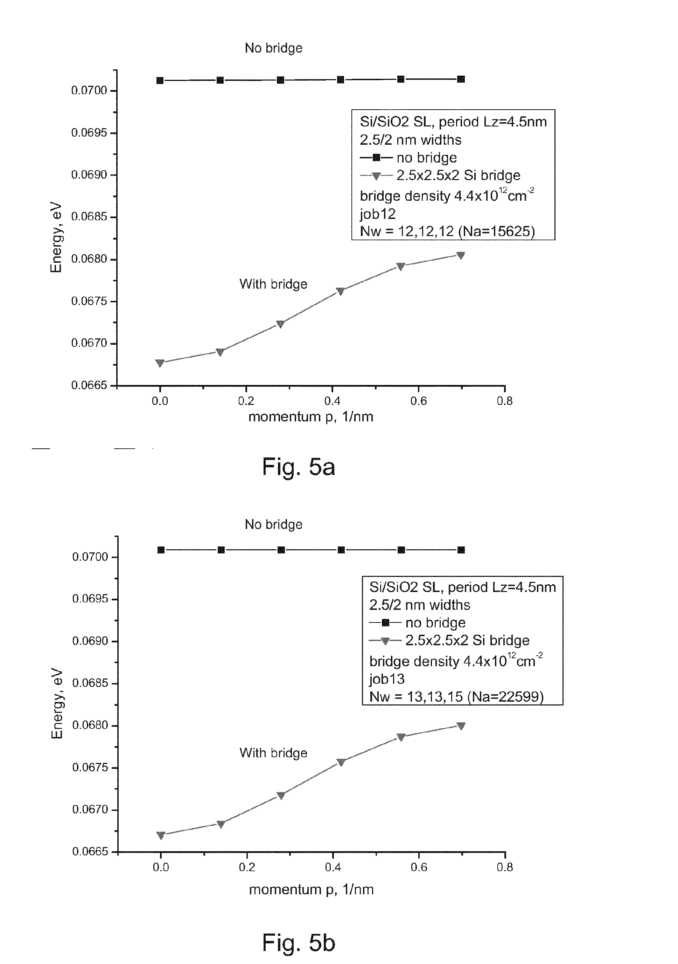

Referring to Figures 5a and 5b, plots of ground level energy dependence on momentum ($p_z$) for the two structures 18, 19 for different matrix sizes (Na = 15625 and Na = 22599) are shown. The plots confirm that the calculations have indeed converged.

Referring in particular to Figure 5b, a level width is defined, namely :

$$\text{Level width} = \max(E(p_z)) - \min(E(p_z)) \qquad (4)$$

where the max and min values are taken with respect of variation of $p_z$ in the interval $p_z = [0, \pi/L_z]$.

As shown on the Figure 5b, for the ground level, the line width is:

$$\text{Level width} = \text{Energy}(p_z = \pi/L_z) - \text{Energy}(p_z = 0) \qquad (4')$$

For higher levels (and a general case), the line width is calculated using equation (4) above.

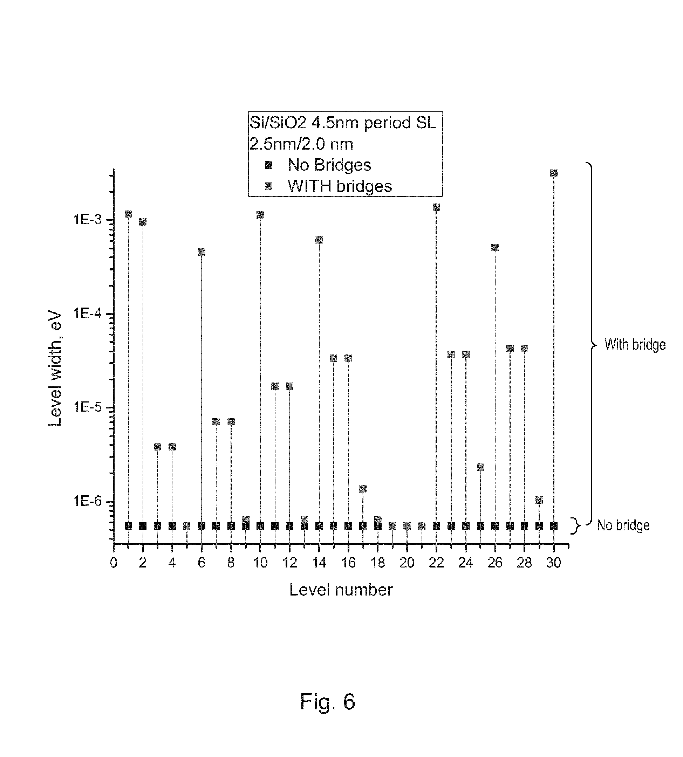

Figure 6 shows (using a logarithmic energy scale) a comparison of level widths for the first and second structures 18 (Figure 4a), 19 (Figure 4b) for the first thirty energy levels.

As shown in Figure 6, the level widths for the structure 18 (Figure 4a) having no bridge have low values, around $5 \times 10^{-7}$ eV, for level numbers between 1 and 30. However, the level widths for the structure 19 (Figure 4b) having a bridge change from about $5 \times 10^{-7}$ eV to about $3 \times 10^{-3}$ eV according to level number indicating that some levels (e.g. 1, 2, 6, 14, 22, 26, and 30) have much larger level widths (e.g. at least two orders of magnitude) which are indicative of higher transmission probabilities.

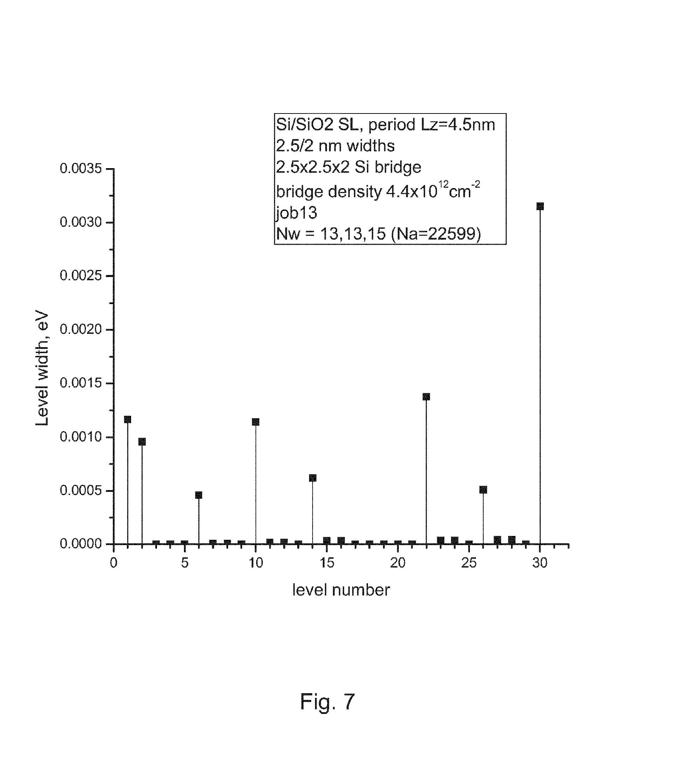

Figure 7 shows level widths (in this case with a linear energy scale) for the second structure 19 (Figure 4b) for the first thirty energy levels.

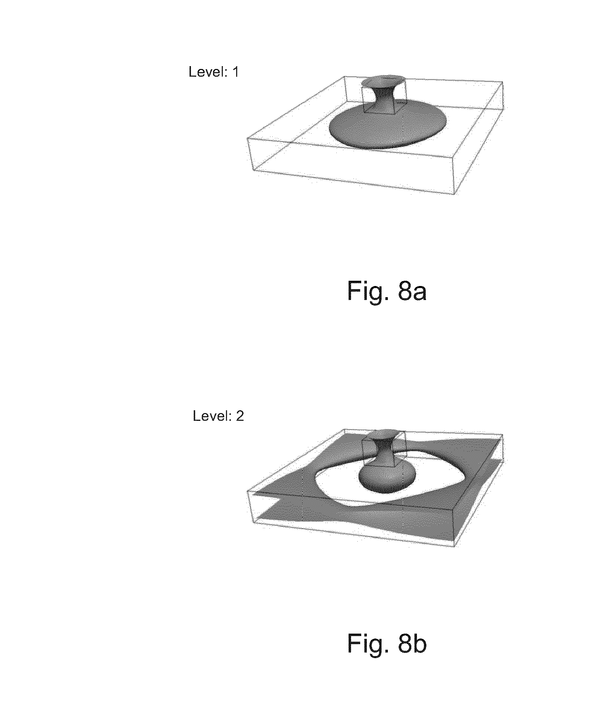

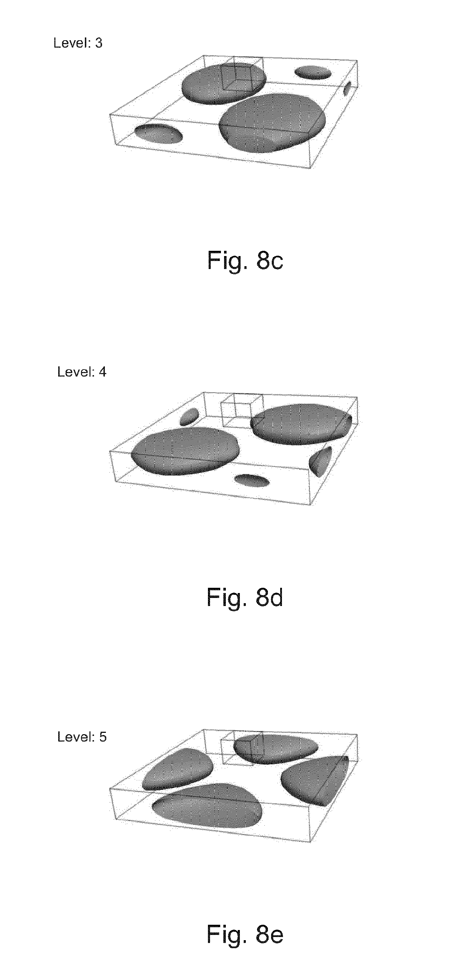

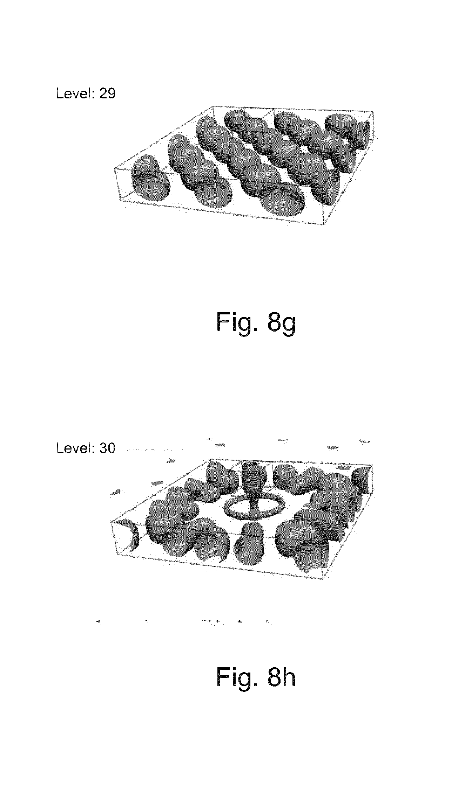

Figures 8a to 8h show probability distribution of wavefunctions (i.e. $|\psi|^2$) for the first, second, third, fourth, fifth, sixth, twenty-ninth and thirtieth energy levels respectively.

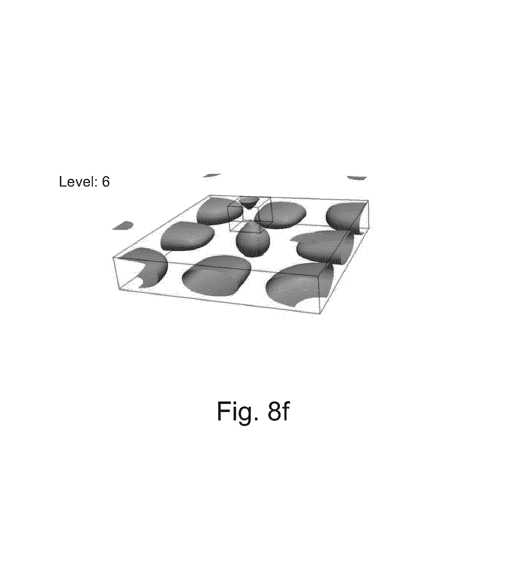

As shown in Figures 8a, 8b, 8f, and 8h, those levels which exhibit large level widths have probability distributions which extend into the bridge region 21 corresponding to hybrid state. In the other states, only quantum well states are exhibited.

Thus, introducing nanobridges into a silicon/silicon dioxide "superlattice" in the form of small silicon quantum dots dramatically improves transport between silicon quantum well layers. However, the optical properties of the "superlattice" are not substantially changed.

The optical properties of the "superlattice" can still be tuned to a given absorption wavelength by changing the thickness of the silicon quantum wells. The transport properties of the "superlattice" can be controlled using the lateral size and density of the nanobridges.

If the nanobridges are made larger, quantum confinement will be reduced and the impact on the absorption wavelength will increase. Thus, for lateral dimensions of about 50 nm or more, the nanobridges will generally have deleterious effect.

The multiple quantum well structure 1 can be fabricated a deposition processes, such as molecular beam epitaxy (MBE), atomic layer deposition (ALD), physical vapour deposition (PVD) or chemical vapour deposition (CVD), and/or conversion processes, such as oxidation or nitridation.

The multiple quantum well structure 1 can be fabricated using self-aligning, self-organising and/or self-limiting processes. Additionally or alternatively, high resolution (e.g. X-Ray or electron-beam) lithography can be used.

For example, silicon may be deposited, for example using a CVD process, using feed gases and reactor conditions (e.g. deposition temperature, substrate temperature and ambient pressure) which lead to deposition of silicon and simultaneous oxidation in most, but not all regions, of silicon. Alternatively, silicon may first be deposited and the oxidized in some, but not all regions. Partial oxidation (i.e. oxidation in some regions, but not all regions) may be achieved by limiting oxidizing at low pressures. Processes which lead to formation of pin holes in dielectric layers or nucleation of semiconductor material in thin layers of dielectric layers may be used. The process may employ surfactants to cause localised deposition or nucleation. In some embodiments, annealing may be used to cause clustering. These processes may lead to formation of silicon (or other semiconductor material) nano-islands.

For example, silicon nanobridge may be formed by silicon nanocrystal deposition (including nanocrystals coated with organic materials which is subsequently removed by evaporation), by silicon-rich oxide formation or by silicon island formation. Once the nanobridges and barriers have been formed, silicon quantum wells can be formed, for example, by CVD. The process is then repeated n-times to form n-periods of the superlattice. A capping layer silicon may be deposited. After the layers have been deposited the structure can be annealed.

Reference is made to G. Ammendola et al.: "Nanocrystal metal-oxide-semiconductor memories obtained by chemical vapor deposition of Si nanocrystals", J. Vac. Sci. Technol. B 20, 2075 (2002) and Y. Chao et al.: "Evaporation and deposition of alkyl-capped silicon nanocrystals in ultrahigh vacuum" Nature Nanotechnology 2, 486 - 489 (2007).

In some embodiments, the process may involve depositing a barrier layer, forming and patterning a mask on the layer using a lithographic process, etching holes in the barrier layer using dry or wet etching and filling the holes with material. A layer of quantum well material is then deposited. The process is then repeated.

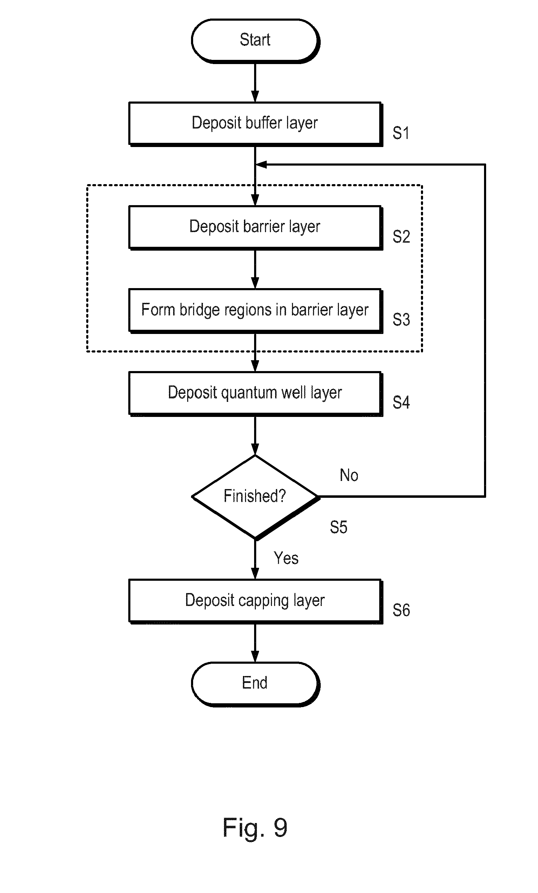

Referring to Figure 9, a flow diagram of a method of fabricating the multiple quantum well structure 1 is shown.

A buffer layer of semiconductor material, e.g. silicon, may first be deposited (step S1). The barrier layer is then deposited (step S2). Bridge regions may be formed in the barrier layer either simultaneously or subsequently (step S3). As shown in Figure 9, the bridge regions and the barrier regions may be formed at the same time. A quantum well layer is then deposited (step S4). The process is repeated for as many times as necessary (step S5). A capping layer, e.g. of highly-doped silicon, may be deposited (step S6).

It will be appreciated that many modifications may be made to the embodiments hereinbefore described.

For example, the quantum well layers may be formed from monocrystalline or polycrystalline material.

**Claims**

1.  A multiple quantum well structure comprising:

    a multiple layer structure comprising alternating well and barrier layers comprising first and second materials respectively stacked in a first direction,

    wherein each barrier layer has a plurality of holes filled with a third material so to form a plurality of respective bridge regions through the layer which connect adjacent well layers, the bridge regions having dimensions of no more than 50 nm in directions perpendicular to the first direction.

2.  A multiple quantum well structure according to claim 1, wherein the first material is silicon.

3.  A multiple quantum well structure according to claim 1 or 2, wherein the second material is a dielectric material.

4.  A multiple quantum well structure according to claim 3, wherein the dielectric material comprises silicon.

5.  A multiple quantum well structure according to claim 4, wherein the dielectric material comprises silicon oxide.

6.  A multiple quantum well structure according to claim 4 or 5, wherein the dielectric material comprises silicon nitride.

7.  A multiple quantum well structure according to any one of claims 1 to 6, wherein the first and third materials are the same.

8.  A multiple quantum well structure according to any one of claims 1 to 6, wherein the first and third materials are the different.

9.  A multiple quantum well structure according to any preceding claim, wherein the bridge regions have dimensions of no more than 40 nm in directions perpendicular to the first direction.

10. A multiple quantum well structure according to any preceding claim, wherein the bridge regions have dimensions of no more than 20 nm in directions perpendicular to the first direction.

11. A multiple quantum well structure according to any preceding claim, wherein the bridge regions have dimensions of no more than 10 nm in directions perpendicular to the first direction.

12. A photovoltaic cell comprising:

    first and second contacts; and
    multiple quantum well structure according to any preceding claim disposed between said first and second contacts.

13. A method, comprising:

    connecting a load across one or more photovoltaic cells according to any preceding claim; and
    arranging the photovoltaic cell such that, during daytime, the photovoltaic cell is exposed to sunlight.

14. A method of fabricating a multiple quantum well structure, the method comprising:

    providing alternating well and barrier layers comprising first and second materials respectively stacked in a first direction,

wherein each barrier layer has a plurality of holes filled with a third material so to form a plurality of respective bridge regions through the layer which connect adjacent well layers, the bridge regions having dimensions of no more than 50 nm.

Fig. 1

Fig. 1a

Fig. 2

Fig. 3a

Fig. 3b

Fig. 4a

Fig. 4b

Fig. 5a

Fig. 5b

Fig. 6

Fig. 7

Level: 1

Fig. 8a

Level: 2

Fig. 8b

Level: 3

Fig. 8c

Level: 4

Fig. 8d

Level: 5

Fig. 8e

Level: 6

Fig. 8f

Level: 29

Fig. 8g

Level: 30

Fig. 8h

Start

Deposit buffer layer S1

Deposit barrier layer S2

Form bridge regions in barrier layer S3

Deposit quantum well layer S4

Finished? No
S5
Yes

Deposit capping layer S6

End

Fig. 9

Europäisches
Patentamt

European
Patent Office

Office européen
des brevets

# EUROPEAN SEARCH REPORT

**Application Number**

EP 11 18 9350

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | DE 10 2009 029017 A1 (BOSCH GMBH ROBERT [DE]) 3 March 2011 (2011-03-03) * figures 1, 2B and associated text * * paragraph [0012] * ----- | 1-7,9-14 | INV. H01L29/15 H01L31/0352 |
| X | WO 2011/017773 A1 (NEWSOUTH INNOVATIONS PTY LTD [AU]; KOENIG DIRK [AU]) 17 February 2011 (2011-02-17) * figures 4, 5 and associated text * * page 1 * ----- | 1,3-6, 8-14 | |
| X,D | EP 1 505 698 A2 (SAMSUNG ELECTRONICS CO LTD [KR]) 9 February 2005 (2005-02-09) * figures 2, 6B, 7A, 8 * ----- | 1-7,9-14 | |
| A | EP 2 187 445 A1 (HITACHI LTD [JP]) 19 May 2010 (2010-05-19) * figure 26 and associated text * ----- | 1-14 | |

| | | | TECHNICAL FIELDS SEARCHED (IPC) |
|---|---|---|---|
| | | | H01L |

The present search report has been drawn up for all claims

| Place of search | Date of completion of the search | Examiner |
|---|---|---|
| Munich | 1 June 2012 | Moehl, Sebastian |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 11 18 9350

This annex lists the patent family members relating to the patent documents cited in the above-mentioned European search report.
The members are as contained in the European Patent Office EDP file on
The European Patent Office is in no way liable for these particulars which are merely given for the purpose of information.

01-06-2012

| Patent document cited in search report | Publication date | Patent family member(s) | Publication date |
|---|---|---|---|
| DE 102009029017 A1 | 03-03-2011 | DE 102009029017 A1<br>WO 2011023441 A2 | 03-03-2011<br>03-03-2011 |
| WO 2011017773 A1 | 17-02-2011 | NONE | |
| EP 1505698 A2 | 09-02-2005 | AT 442669 T<br>CN 1581528 A<br>EP 1505698 A2<br>JP 2005057262 A<br>KR 20050017685 A<br>US 2005029506 A1 | 15-09-2009<br>16-02-2005<br>09-02-2005<br>03-03-2005<br>23-02-2005<br>10-02-2005 |
| EP 2187445 A1 | 19-05-2010 | NONE | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1505698 A
- EP 1860600 A

- EP 2187445 A

**Non-patent literature cited in the description**

- **S. M. SZE.** Physics of Semiconductor Devices. Wiley, 1981
- **M. A GREEN.** Modern Semiconductor Device Physics. Wiley, 1998
- **LOCKWOOD D. J.** Band Gap of Nanometer Thick Si/SiO2 Quantum Wells: Theory versus Experiment. *Proceedings Of The Society Of Photo-Optical Instrumentation Engineers (SPIE,* 2008, vol. 7099, F991-F991
- **BRENDEL R.** A novel process for ultrathin monocrystalline silicon solar cells on glass. *14th European Photovoltaic Solar Energy Conference,* 30 June 1997
- **SHIR D. et al.** Performance of Ultrathin Silicon Solar Microcells with Nanostructures of Relief Formed by Soft Imprint Lithography for Broad Band Absorption Enhancement. *Nano Letters,* 2010, vol. 10, 3041-3046
- **YOON J. et al.** Ultrathin silicon solar microcells for semitransparent, mechanically flexible and microconcentrator module designs. *Nature Materials,* 2008, vol. 7, 907-915
- **FERRY V. E.** Light trapping in ultrathin plasmonic solar cells. *Optics Express,* 2010, vol. 18, A237-A245
- **ODA S.** NeoSilicon materials and silicon nanodevices. *Material Science and Engineering B,* 2003, vol. 101, 19-13

- **ROSINI M. et al.** Monte Carlo simulation of electron transport in Si/SiO2 superlattices: Vertical transport enhanced by a parallel field. *Physical Review B,* 2000, vol. 66, 155332
- **RÖLVER R. et al.** Si/SiO2 multiple quantum wells for all silicon tandem cells: Conductivity and photocurrent measurements. *Thin Solid Films,* 2008, vol. 516, 6763-6766
- **JIANG C-W et al.** Silicon quantum dot superlattices: Modeling of energy bands, densities of states, and mobilities for silicon tandem solar cell applications. *Journal of Applied Physics,* 2006, vol. 99, 114902
- **MALGUTH E. et al.** Development of ultra-thin tunneling oxides and Si/SiO2 nanostructures for the application in silicon solar cells. *Physica Status Solidi A,* 2011, vol. 208, 612-615
- **G. AMMENDOLA et al.** Nanocrystal metal-oxide-semiconductor memories obtained by chemical vapor deposition of Si nanocrystals. *J. Vac. Sci. Technol. B,* 2002, vol. 20, 2075
- **Y. CHAO et al.** Evaporation and deposition of alkyl-capped silicon nanocrystals in ultrahigh vacuum. *Nature Nanotechnology,* 2007, vol. 2, 486-489